# EUROPEAN PATENT SPECIFICATION

(11) **EP 1 870 723 B1**
(45) Date of publication and mention of the grant of the patent: **28.01.2009**
(21) Application number: 06255150.2
(22) Date of filing: 05.10.2006
(51) Int. Cl.: G01R 31/317, G01R 31/3185

(54) **Integrated circuit**
Integrierte Schaltung
Circuit intégré

(30) Priority: 19.06.2006 JP 2006168830
(43) Date of publication of application: 26.12.2007
(73) Proprietor: Fujitsu Ltd., Kawasaki-shi, Kanagawa 211-8588 (JP)
(72) Inventor: Otake, Takashi, c/o Fujitsu Limited, Kawasaki-shi, Kanagawa 211-8588 (JP); Konmoto, Akihiko c/o Fujitsu Limited, Kawasaki-shi, Kanagawa 211-8588 (JP)
(74) Representative: Stebbing, Timothy Charles

(56) References cited:
- EP-A2- 0 867 727
- US-A- 5 107 153
- US-A1- 2001 014 851
- US-B1- 6 598 187
- US-B1- 6 731 158

## Description

The present invention relates to an integrated circuit including a first latch of a data transmitting source and a second latch of a data receiving destination, and to a method of testing such an integrated circuit.

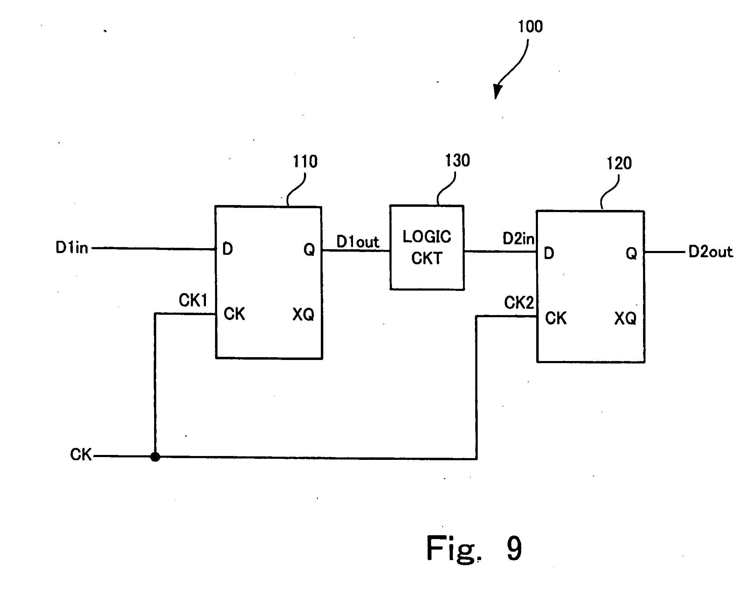

There is a test called WDFT (W (double) clock Dynamic Function Test)) as one of the tests used to detect the breakdown of the integrated circuit, done with an LSI tester. According to this test, an input signal is entered from the LSI tester to the first latch of the data transmitting source provided in the integrated circuit, and a test is performed of whether the second latch of the data receiving destination can take in (receive) the input signal transmitted from the first latch. Hereinafter, there will be explained the operation of the first latch in the integrated circuit to which this test is done and the second latch referring to Figure 9, Figure 10, and Figure 11.

Fig. 9 is a block diagram of the conventional integrated circuit having a first latch of a data transmitting source and a second latch of a data receiving destination.

An integrated circuit 100 shown in Fig. 9 comprises a first latch 110 of a data transmitting source, a second latch 120 of a data receiving destination, and a logic circuit (gate circuit) 130 disposed between the first latch 110 and the second latch 120.

A data input terminal D of the first latch 110 receives data D1in representative of an input signal from a LSI tester. Clock terminals CK of the first latch 110 and the second latch 120 receive clocks CK from the LSI tester. For the sake of the convenience, the clock CK, which is fed to the clock terminal CK of the first latch 110, is denoted as a clock CK1, and the clock CK, which is fed to the clock terminal CK of the second latch 120, is denoted as a clock CK2.

The first latch 110 takes in the entered data D1in in synchronism with rising of the clock CK1, and outputs the data to an output terminal Q of the first latch 110 in form of data D1out. The second latch 120 takes in the data D2in, which is entered through the logic circuit 130, in synchronism with rising of the clock CK2, and outputs the data to an output terminal Q of the second latch 120 in form of data D2out.

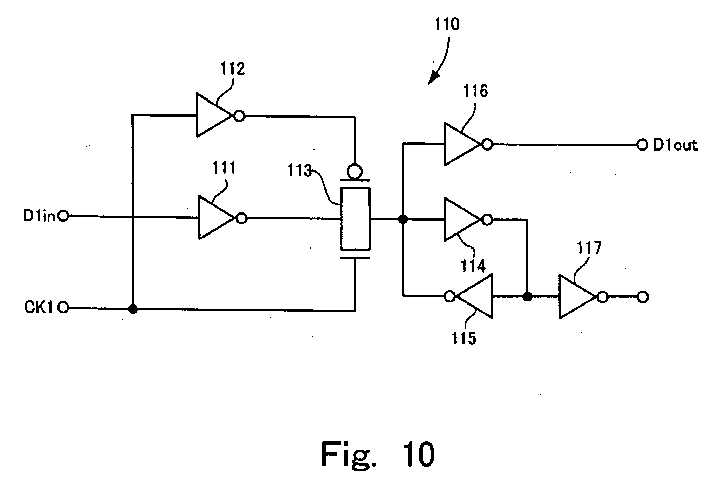

Fig. 10 is a view of a circuit structure of the first latch 110 shown in Fig. 9.

It is noted that a circuit structure of the second latch 120 shown in Fig. 9 is also the same as the circuit structure of the first latch 110.

The first latch 110 shown in Fig. 9 comprises an inverter 111 that receives the data D1in, an inverter 112 that receives the clock CK1, and a transmission gate 113. The first latch 110 further comprises a pair of inverters 114 and 115 whose outputs are connected to each other's inputs, an inverter 116 that outputs the data D1out, and an inverter 117 that outputs data inverted in logic of the data D1out.

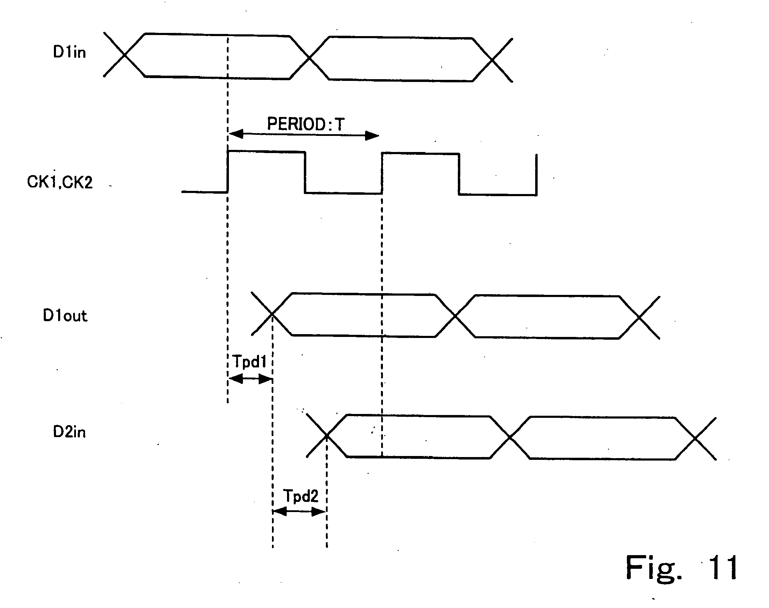

Fig. 11 is a time chart of the first latch 110 and the second latch 120 shown in Fig. 10.

The time chart shown in Fig. 11 is a time chart showing an ideal state in which there is no delay between the clock CK1 and the clock CK2 shown in Fig. 9.

The data D1in shown in Fig. 11 is fed to the first latch 110. The clock CK1 having a period T shown in Fig. 11 is also fed to the first latch 110. When the clock CK1 rises from an "L" level to an "H" level, the transmission gate 113, which constitutes the first latch 110, turns on, so that the data D1in is fed via the inverter 111 to the pair of inverters 114 and 115. The pair of inverters 114 and 115 maintains the level of the entered data D1in, and the data D1out as an output of the inverter 116 is transferred via the logic circuit 30 to the second latch 120 in form of data D2in.

Thus, in the first latch 110, when the clock CK1 offers the "H" level, the data D1in fed to the data input terminal D is transferred to the data output terminal Q in the form of the data D1out, and thereafter, when the clock CK1 changes in level to the "L" level, the data D1in is shut out, i.e. prevented from transfer to the data output terminal Q. At that time, in the first latch 110, the data D1in, which is transmitted when the clock CK1 offers the "H" level, is held in the pair of inverters 114 and 115, and is outputted in form of the data D1out. In this manner, the data output of the first latch 110 changes only at the time point when the clock CK1 offers the "H" level. The data D1out outputted from the first latch 110 is fed via the logic circuit 130 to the second latch 120 in form of the data D2in, so that the data D2in is taken in the second latch 120 at the rise timing of the clock CK2.

In the integrated circuit 100 shown in Fig. 9, in the event that the first latch 110 takes in the data D1in, and then the second latch 120 takes in the data D2in via the logic circuit 130, as shown in Fig. 11, there is a need to consider a delay time Tpd1 (a time from rising of the clock CK1 to the output of the data D1out) of the first latch 110 and a delay time Tpd2 of the logic circuit 130. Further, there is a need to consider a setup time and a hold time too.

The setup time is a minimum time that will be needed for the identification of the value of data, and the fixation when the latch takes data with the clock.

The holding time (Hold) is the minimum time needed to maintain the value of data when the latch takes data with the clock.

Defective holding is caused when it is small to extent for the delay at the delay time Tpd1 + the delay time Tpd2 not to satisfy the holding time of the latch of the data destination when it is small.

To test the margin of the holding time of the data holding circuit such as flip-flops provided in the manufactured integrated circuit as part of the delivery inspection, there is proposed an integrated circuit that has a buffer where the clock is delayed with a predetermined delay amount from a usual operating timing, and when the margin of the holding time is tested, the clock is delayed in an amount of delay that is bigger than the predetermined amount of the delay (refer to Japanese Patent Publication TokuKai 2005-293622). According to the integrated circuit disclosed in Japanese Patent Publication TokuKai 2005-293622, it is possible to test the margin of the holding time that has depended only on the design guarantee while mounted.

In general, an integrated circuit may be vulnerable to a so-called stack breakdown in which the signal (the signal at the 'H' the level or the 'L' level) at desired level cannot be derived owing to defective holding that is generated when the holding time cannot be secured, or short-circuit and the disconnection, etc. of the internal wiring. Even if the technology disclosed in Japanese Patent Publication TokuKai 2005-293622 mentioned above is adopted so that the margin of the holding time is evaluated to reflect the evaluation result, the large margin may involve a decrease in operation speed, and thus it is difficult to prevent the possibility that defective holding is generated owing to the manufacturing process etc.

According to the conventional integrated circuit, it is difficult for an LSI tester to discriminate between defective holding and stack breakdown. It will be decided that an integrated circuit is defective without knowing whether defective holding or stack breakdown is the cause. When defective holding occurs, it is preferable to feed back information about such a defect to the design phase of the integrated circuit and to improve it. However, according to the conventional integrated circuit, it is difficult to discriminate between the defective holding and the stack breakdown. Thus, it is difficult to feed back information about defective holding to the design phase of the integrated circuit.

US 2001/0014851 discloses a method for determining the setup and hold times of static flip-flops during the design and development of integrated circuits. The method utilizes simulations of an integrated circuit to determine a first amount of time required for a data signal to be transmitted from a first external node to a predetermined node in the register of a static flip-flop, and a second amount of time required for a clock signal to be transmitted from a second external node to the predetermined node. The setup time is determined by calculating a difference between the first amount of time and the second amount of time. Similarly, a hold time for the flip-flop is determined by calculating a difference between the amounts of time required for data and the clock signal to reach a second predetermined internal node of the flip-flop.

In view of the foregoing, it is desirable to provide an integrated circuit in which it is possible to discriminate between defective holding and stack breakdown (short circuit or a disconnection of wiring) by an LSI tester.

An aspect of the present invention provides a first integrated circuit including a first latch of a data transmitting source, a second latch of a data receiving destination and a logic circuit between the first latch and the second latch, the second latch comprising:
an input buffer that buffers an input signal transmitted from the first latch; and
a back bias applying circuit arranged to delay a signal to be tested, by applying a back bias to the input buffer at a time of a test operation.

Thus, in the first integrated circuit of the present invention, the second latch comprises: the input buffer that buffers an input signal transmitted from the first latch; and the back bias applying circuit that applies a back bias to the input buffer at time of a test operation. This feature makes it possible to delay the signal when the back bias is applied to the input buffer. Thus, according to the first integrated circuit of the present invention, it is possible to discriminate between the defective holding and the stack breakdown (short circuit or a disconnection of wiring) by an LSI tester.

In another aspect, the present invention provides a second integrated circuit including a first latch of a data transmitting source, a second latch of a data receiving destination and a logic circuit between the first latch and the second latch, the first latch comprising:
an output buffer that buffers a signal outputted from the first latch; and
a back bias applying circuit arranged to delay a signal to be tested, by applying a back bias to the output buffer at a time of a test operation.

Thus, in the second integrated circuit of the present invention, the first latch comprises: the output buffer that buffers a signal outputted from the first latch; and the back bias applying circuit that applies a back bias to the output buffer at time of a test operation. This feature makes it possible to delay the signal from the output buffer when the back bias is applied to the output buffer. Thus, according to the second integrated circuit of the present invention, it is possible to discriminate between the defective holding and the stack breakdown by an LSI tester.

The present invention also provides a method of testing the first and second integrated circuits, comprising: first testing whether an input signal, which bypasses the back bias applying circuit, can be taken into the second latch, and if so judging that the integrated circuit has passed, and in the event that the input signal cannot be taken into the second latch, judging that the integrated circuit is defective; and secondly testing whether the input signal can be taken into the second latch, even when the input signal is delayed via the back bias applying circuit, and if not judging that the integrated circuit is in a state of a short circuit or a disconnection of wiring (stack breakdown), whereas in the event that the input signal can be taken into the second latch when the input signal is delayed through passing via the back bias applying circuit, judging that the integrated circuit is in a defective holding state. Thus, according to the first and second integrated circuits of the present invention, it is possible to discriminate between the defective holding state and the short circuit/disconnection of wiring (stack breakdown) state of an LSI tester.

Reference is made, by way of example only, to the

accompanying drawings in which:
Fig. 1 is a block diagram showing a structure of a first embodiment of a first integrated circuit of the present invention.
Fig. 2 is a block diagram showing a circuit structure of a second latch showing in Fig. 1.
Fig. 3 is a timing chart useful for understanding an integrated circuit in a state of defective holding.
Fig. 4 is a block diagram showing a circuit structure of the second latch that constitutes a second embodiment of the first integrated circuit of the present invention.
Fig. 5 is a block diagram showing a structure of an embodiment of a second integrated circuit of the present invention.
Fig. 6 is a block diagram showing a circuit structure of the second latch showing in Fig. 5.
Fig. 7 is a block diagram showing a structure of an embodiment of a third integrated circuit of the present invention.
Fig. 8 is a block diagram showing a circuit structure of the first latch showing in Fig. 7.
Fig. 9 is a block diagram of the conventional integrated circuit having a first latch of a data transmitting source and a second latch of a data receiving destination.
Fig. 10 is a view of a circuit structure of the first latch shown in Fig. 9.
Fig. 11 is a time chart of the first latch and the second latch shown in Fig. 10.

Embodiments of the present invention will be described with reference to the accompanying drawings.

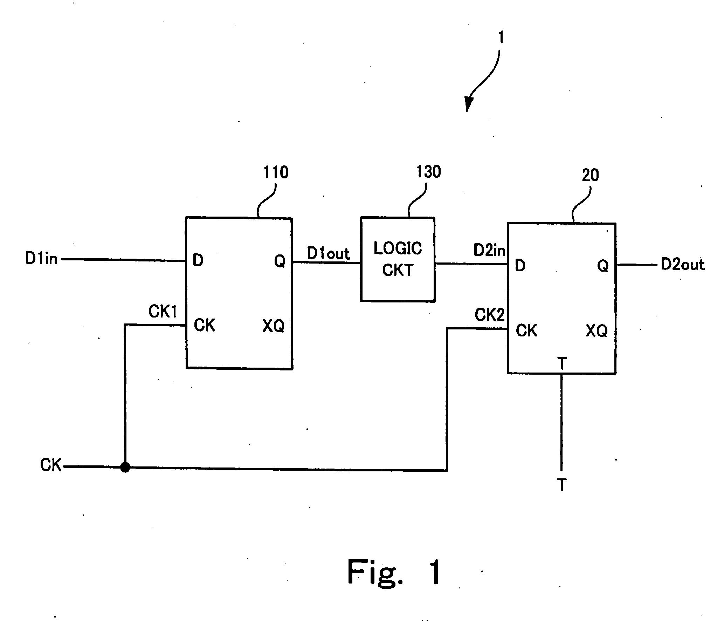

Fig. 1 is a block diagram showing a structure of a first embodiment of a first integrated circuit of the present invention.

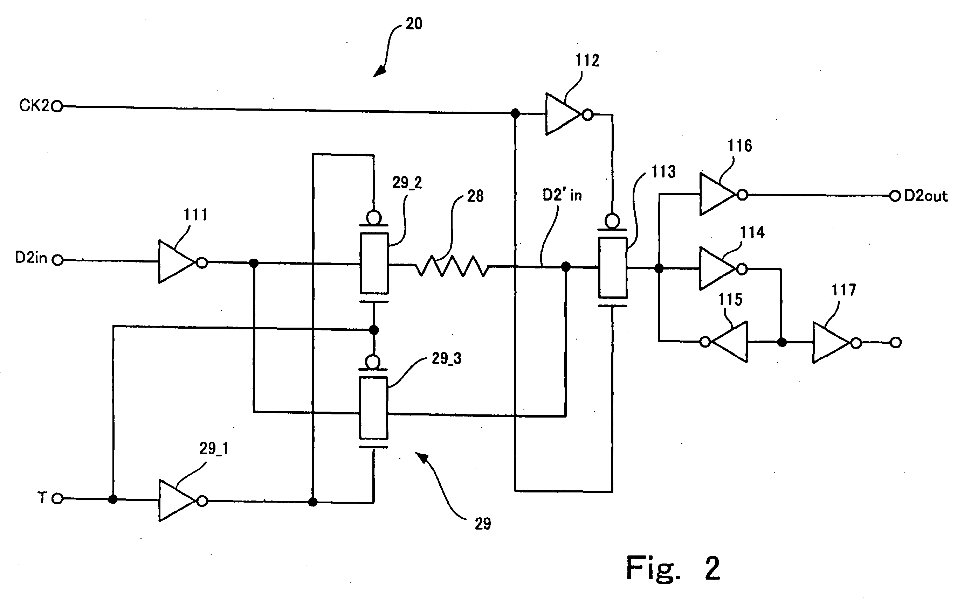

An integrated circuit 1 shown in Fig. 1 comprises the first latch 110 of a data transmitting source, which is the same as one shown in Fig. 9, a second latch 20 of a data receiving destination, which is the feature of the present embodiment, and a logic circuit 130 disposed between the first latch 110 and the second latch 20. While the structure of the second latch 20 would be explained with reference to Fig. 2, the second latch 20 has a data input terminal D to receive data D2in, a clock terminal CK to receive a clock CK2, and a signal input terminal T to receive a signal T which will be described later.

Fig. 2 is a block diagram showing a circuit structure of a second latch showing in Fig. 1.

In Fig. 2, the same parts are denoted by the same reference numbers as those of Fig. 10. Only different points will be explained and redundant explanation will be omitted.

The second latch 20 shown in Fig. 2 comprises a resistance element 28, and a path switching circuit 29 in addition to the structural elements shown in Fig. 10.

The resistance element 28 is a delay element for delaying data D2in representative of an input signal transmitted from the first latch 110. The resistance element 28 is disposed on a signal path.

The path switching circuit 29 comprises an inverter 29_1 and transmission gates 29_2 and 29_3. The path switching circuit 29 changes over a signal input path to take in data D2'in which is delayed via the resistance element 28.

First, there will be explained the usual operation of the integrated circuit 1 capable of taking the data D2'in that bypasses the resistance element 28 into the second latch 20, in conjunction with Fig. 1 and Fig. 2.

The first latch 110, which constitutes the integrated circuit 1 shown in Fig. 2, receives the data D1in and the clock CK1. The first latch 110 inputs the data D1in at the rise timing of the clock CK1 and outputs data D1out. The data D1out is fed via the logic circuit 130 to the second latch 20 in form of data D2in. The second latch 20 also receives the clock CK2 and a signal T of 'L' level.

In more detail, the 'L' level is fed to the path switching circuit 29 which constitutes the second latch 20 shown in Fig. 2. As a result, the transmission gates 29_2 and 29_3 turn off and turn on, respectively, so that the data D2in is taken via the transmission gate 29_3, or bypasses the resistance element 28, and via the transmission gate 113 into the pair of inverters 114 and 115, and is outputted via the inverter 116 in form of the data D2out.

As for the manufactured integrated circuit 1, there is performed a test (below called the first test) that simply judges whether the integrated circuit 1 is faulty or not prior to shipment. After this test, in the event that it is judged that the integrated circuit 1 is defective, there is performed another test (below called the second test) to distinguish whether the defect is due to defective holding or stack breakdown. To explain the first test and the second test, defective holding in the integrated circuit 1 will be described.

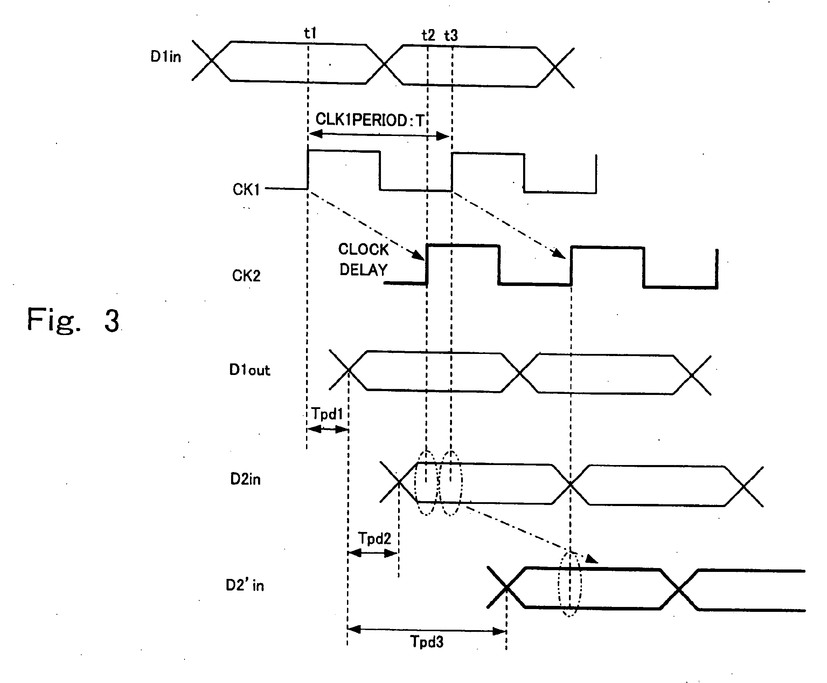

Fig. 3 is a timing chart useful for understanding the integrated circuit in a state of defective holding.

In an LSI tester, a signal T at the 'L' level is input to the second latch 20 shown in Fig. 2 as the first test. Moreover, the clock CK1, which has data D1in shown in Fig. 3 and a period T, is input to the first latch 110.

The first latch 110 takes the data D1in in timing of rising t1 of the clock CK1 (refer to Fig. 3), and outputs the data D1out with delay by a delay time Tpd1 that the first latch 110 possesses. The data D1out is input to the second latch 20 as data D2in with delay by a delay time Tpd2 that the logic circuit 130 possesses.

The second latch 120 receives the clock CK2 shown in Fig. 3. The clock CK2 is delayed by about 3/4 of the period T of CK1 owing to variations in manufacturing and the like. That is, the rising t2 of the clock CK2 is between the rising t1 of clock CK1 and the following rising t3, and it exists at the time following delay time Tpd2. Therefore, it is impossible to take the data D2in normally and thus it is simply judged that the IC is defective in the first test. When the integrated circuit 1 is acceptable, the data D2in is normally taken in timing of rising of the clock CK2 that is almost the same timing as rising t3 of clock CK1 shown in this Fig. 3.

Next, the second test is performed. In the second test, the signal T of 'H' level is fed to the second latch 20, so that the transmission gates 29_2 and 29_3, which constitute the second latch 20, turn on and turn off, respectively. When the transmission gate 29_2 turns on, the data D2in is delayed by delay time Tpd3 (a total delay time of delay time Tpd2 of the logical circuit 130 + delay time of the resistance element 28) as shown in Fig. 3 via the resistance element 28 and the transmission gate 29_2, so that it becomes data D2'in. The data D2'in is fed to the pair of inverters 114 and 115 in timing of rising t2 of the clock CK2. Thus, in the second test, it is possible to take the data D2in into the second latch 20. Therefore, in the LSI tester, it is decided that the integrated circuit 1 exhibits defective holding.

In the above-mentioned embodiment, there is explained an example in which the test result is defective holding. On the other hand, in a case where the test result shows a stack breakdown, in both the first test and the second test, it is judged that the integrated circuit 1 is defective.

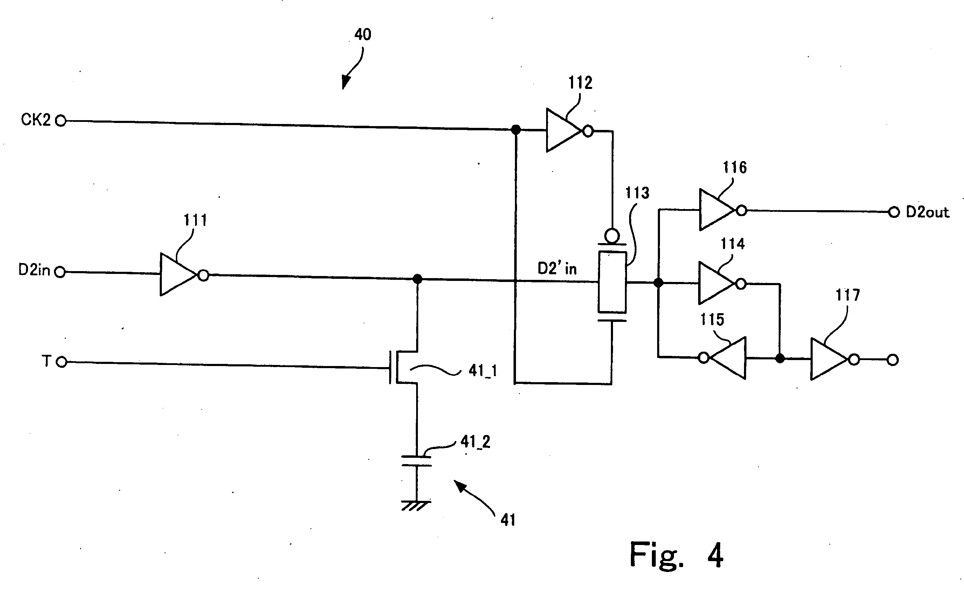

Fig. 4 is a block diagram showing a circuit structure of the second latch that constitutes a second embodiment of the first integrated circuit of the present invention.

According to the embodiment shown in Fig. 4, as compared with the integrated circuit 1 shown in Fig. 1, it is different in the point that the second latch 20 that has the resistive element for the delay of the input signal is replaced by a second latch 40 that has a capacitor for the delay of the input signal.

According to the second latch 40 shown in Fig. 4, there are provided a transistor 41_1 and a capacitor 41_2, which are connected in series, between the signal input path and the ground.

The capacitor 41_2 is a delay element for delaying the data D2in transmitted from the first latch 110.

The transistor 41_1 serves as a path switching circuit for switching the signal input path in such a manner that in the usual operation or the first test, the capacitor 41_2 is bypassed to take the data D2in, and in the second test, the data D2'in is taken via the capacitor 41_2. Hereinafter, a detailed explanation will be made.

First of all, there will be explained usual operation of the integrated circuit functioning correctly, i.e. that can take data D2'in that bypasses the capacitor 41_2 into the second latch 20.

The data D2in transmitted from the first latch 110 is fed to the inverter 111 constituting the second latch 20 shown in Fig. 4. The clock CK2 is fed to the inverter 112 and the transmission gate 113. The 'L' level as the signal T is fed to the transistor 41_1. When the transistor 41_1 receives the 'L' level as the signal T, the transistor 41_1 turns off. As a result, the capacitor 41_2 is disconnected from the signal input path, so that the data D2in is transmitted via the inverter 111 and the transmission gate 113 to the pair of inverters 114 and 115, and then be outputted from the inverter 116 in form of the data D2out.

Next, there will be explained operation of the LSI tester wherein the integrated circuit having the second latch 40 shown in Fig. 4 operates with a great delay between the clock CK1 and clock CK2 owing to variations in manufacturing etc.

The clock CK2 for taking the data D2in is greatly delayed as compared with the clock CK1. Hence, as explained referring to Fig. 3, the data D2in is not input correctly, and in the first test, it is decided that the integrated circuit is simply defective.

Next, in order to distinguish between the stack breakdown and the defective holding, the second test is carried out. In the second test, 'H' level of signal T is entered. When the 'H' level of signal T is applied, the transistor 41_1 turns on, so that the data D2in is delayed by the corresponding capacitance of the capacitor 41_2 and converted into the data D2'in. The data D2'in is applied via the transmission gate 113 to the pair of inverters 114 and 115. Thus, in the second test, it is possible to store the data D2in into the second latch 20. As a result, the LSI tester decides that the integrated circuit shows defective holding. In the event that even in the second test, it is detected that the data D2in is not able to be taken still by the second latch 20, it is judged that the integrated circuit has a stack breakdown problem.

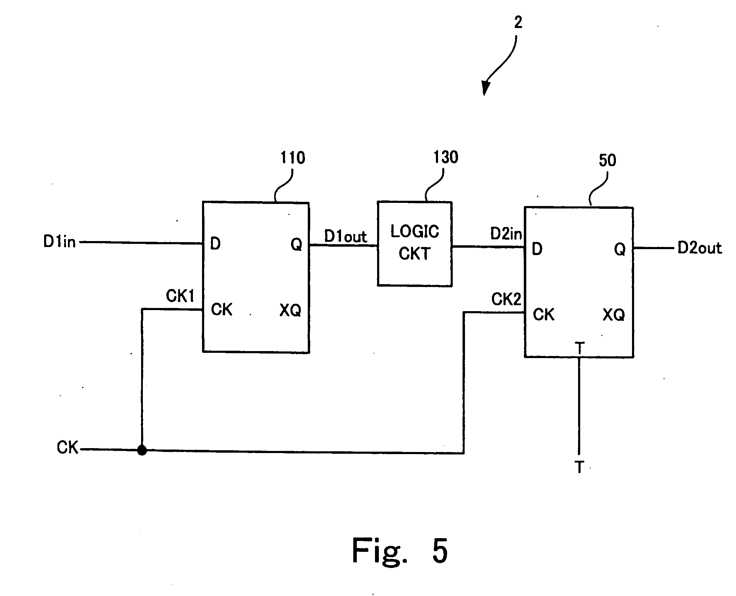

Fig. 5 is a block diagram showing a structure of an embodiment of a second integrated circuit of the present invention.

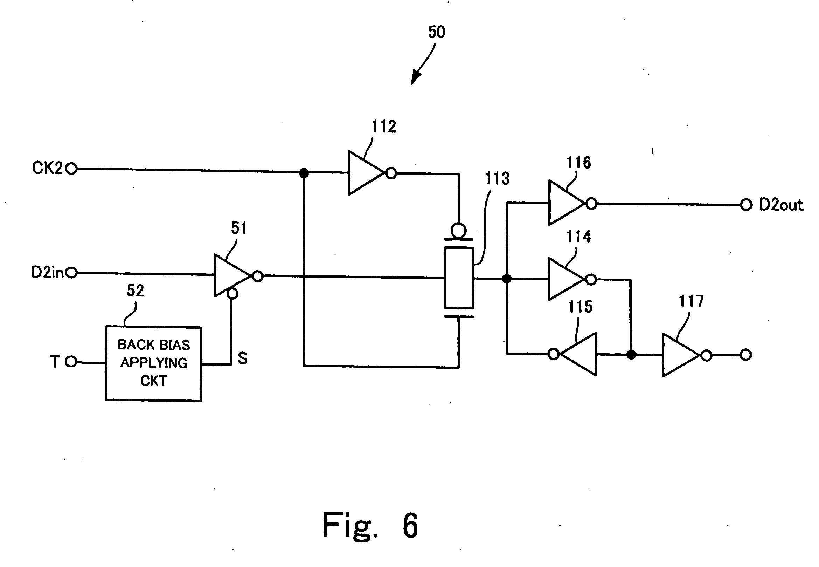

An integrated circuit 2 shown in Fig. 5 is different, as compared with the integrated circuit 1 shown in Fig. 1, in the point that the second latch 20 having the resistance element is replaced by a second latch 50 having an input buffer to which a back bias is applied. Hereinafter, there will be explained the integrated circuit 2 referring to Fig. 6.

Fig. 6 is a block diagram showing a circuit structure of the second latch showing in Fig. 5.

A second latch 50 shown in Fig. 6 has an input buffer 51 for buffering the data D2in transmitted from the first latch 110, and a back bias applying circuit 52 for applying a back bias to the input buffer 51 at the time of test operation.

First of all, there will be explained usual operation of a normal (defect-free) integrated circuit 2 that can take the data D2in into the second latch 50 with the backing bias not applied to the input buffer 51.

The data D2in, which is output from the first latch 110, is input to the input buffer 51 which constitutes the second latch 50 shown in Fig. 6. Moreover, the clock CK2 is input to the inverter 112 and the transmission gate 113. In addition, the 'L' level is input to the back bias applying circuit 52 as signal T. When the 'L' level is input to the back bias applying circuit 52, the back bias applying circuit 52 outputs an 'H' level of back bias S. As a result, the input buffer 51 functions as a usual inverter, the data D2in is taken by a pair of inverters 114 and 115 via the input buffer 51 via the transmission gate 113, and the data Dout is output by the inverter 116.

Next, there will be explained operation of the LSI tester wherein the integrated circuit 2 having the second latch 50 involves a great delay between the clock CK1 and clock CK2 owing to variations in manufacturing etc.

The clock CK2 for taking the data D2in is greatly delayed as compared with the clock CK1. Hence, as explained referring to Fig. 3, it is difficult to take the data D2in. Accordingly, in the first test, it is decided that the integrated circuit is simply defective goods.

Next, to distinguish whether the defect is due to stack breakdown or defective holding, the second test is carried out. In the second test, 'H' level of signal T is entered to the back bias applying circuit 52. When the 'H' level of signal T is applied to the back bias applying circuit 52, the back bias applying circuit 52 applies to the input buffer 51 the back bias S of a level (for example, -1V) that is lower than the ground level. As a result, the operating speed of the input buffer 51 is lowered, so that the data D2in is delayed by the corresponding lowered speed in operation. The delayed data D2in is applied via the transmission gate 113 to the pair of inverters 114 and 115. Thus, in the second test, it is possible to take the data D2in into the second latch 50. As a result, the LSI tester decides that the integrated circuit 2 exhibits defective holding. In the event that even in the second test, it is detected that the data D2in is not able to be taken still by the second latch 50, it is judged that the integrated circuit 2 has a stack breakdown defect.

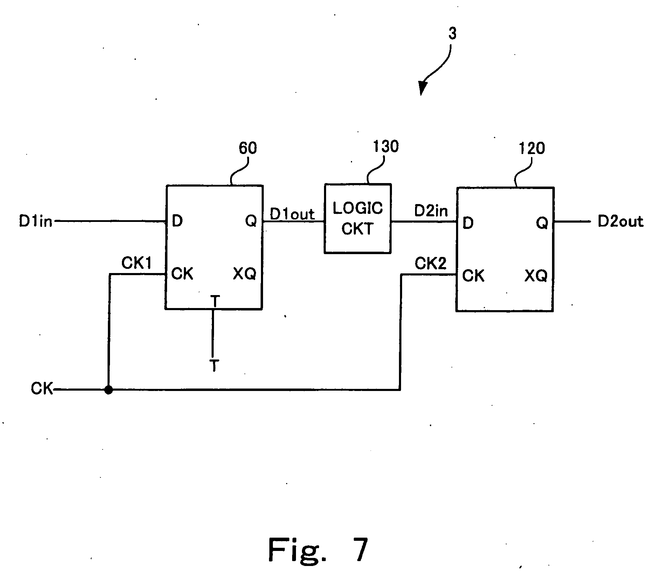

Fig. 7 is a block diagram showing a structure of an embodiment of a third integrated circuit of the present invention.

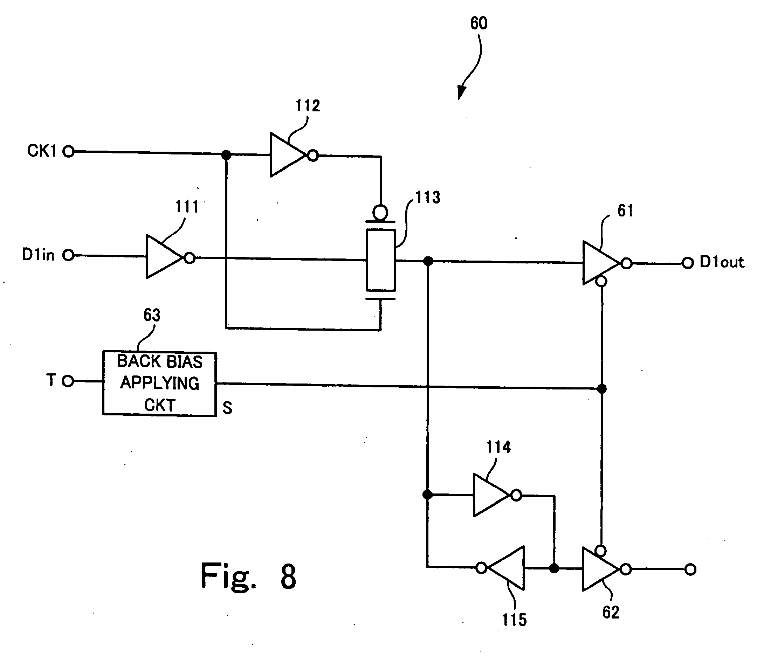

An integrated circuit 3 shown in Fig. 7 has a first latch 60. The first latch 60 will be explained referring to Fig. 8.

Fig. 8 is a block diagram showing a circuit structure of the first latch showing in Fig. 7.

The first latch 60 shown in Fig. 8 has an output buffer 61 for buffering the data D1out transmitted from the first latch 60, and an output buffer 62 for buffering data inverted in logic of the data D1out.

The first latch 60 has further a back bias applying circuit 63 for applying a back bias S to the output buffers 61 and 62 at the time of the test operation.

First of all, there will be explained usual (defect-free) operation of the integrated circuit 3 that can take the data D1in into the second latch 120 with the backing bias not applied to the output buffers 61 and 62.

The data D1in is input to the inverter 111 which constitutes the first latch 60 shown in Fig. 8. Moreover, the clock CK1 is input to the inverter 112 and the transmission gate 113. In addition, the 'L' level is input to the back bias applying circuit 63 as signal T. When the 'L' level is input to the back bias applying circuit 63, the back bias applying circuit 63 outputs an 'H' level of back bias S. The 'H' level of back bias S is applied to the output buffers 61 and 62. As a result, the output buffers 61 and 62 function as a usual inverter, and the data D1in is output via the output buffer 61 in form of the data D1out to the second latch 120.

Next, there will be explained operation of the LSI tester wherein the integrated circuit 3 having the first latch 60 involves a great delay between the clock CK1 and clock CK2 owing to variations in manufacturing etc.

In the second latch 120, the clock CK2 for taking the data D2in is greatly delayed as compared with the clock CK1. Hence, as explained referring to Fig. 3, it is difficult to take the data D2in. Accordingly, in the first test, it is decided that the integrated circuit is simply defective.

Next, to distinguish stack breakdown from defective holding, the second test is carried out. In the second test, 'H' level of signal T is entered to the back bias applying circuit 63. When the 'H' level of signal T is applied to the back bias applying circuit 63, the back bias applying circuit 63 applies to the output buffers 61 and 62 the back bias voltage of a level (for example, -1V) that is lower than the ground level. As a result, the operating speed of the output buffers 61 and 62 is lowered, so that the data D1out, which is delayed by the corresponding lowered operating speed, is outputted to the second latch 120. Hence, the data D2in is delayed, and thus in the second test, it is possible to take the data D2in into the second latch 120. As a result, the LSI tester decides that the integrated circuit 3 shows defective holding. In the event that even in the second test, it is detected that the data D2in is not able to be taken still by the second latch 120, it is judged that the integrated circuit 3 is in a stack breakdown state.

As mentioned above, according to an integrated circuit of the present invention, it is possible to discriminate between the defective holding and the stack breakdown by an LSI tester.

## Claims

1. An integrated circuit (2) including a first latch (110) of a data transmitting source, a second latch (50) of a data receiving destination and a logic circuit (130) between the first latch (110) and the second latch (50), the second latch (50) comprising:
an input buffer (51) that buffers an input signal transmitted from the first latch (110); and
a back bias applying circuit (52) arranged to delay a signal to be tested, by applying a back bias to the input buffer (51) at a time of a test operation.

2. An integrated circuit (3) including a first latch (60) of a data transmitting source, a second latch (120) of a data receiving destination and a logic circuit (130) between the first latch (60) and the second latch (120), the first latch (60) comprising:
an output buffer (61) that buffers a signal outputted from the first latch (60); and
a back bias applying circuit (63) arranged to delay a signal to be tested, by applying a back bias to the output buffer (61) at a time of a test operation.

3. A method of testing the integrated circuit (2,3) according to claim 1 or 2, comprising:
first testing whether an input signal, which bypasses the back bias applying circuit (52,63), can be taken into the second latch (50,120), and if so judging that the integrated circuit (2,3) has passed, and in the event that the input signal cannot be taken into the second latch (50,120), judging that the integrated circuit (2,3) is defective; and
secondly testing whether the input signal can be taken into the second latch (50,120), even when the input signal is delayed via the back bias applying circuit (52,63), and if not judging that the integrated circuit (2,3) is in a state of a short circuit or a disconnection of a wiring, whereas in the event that the input signal can be taken into the second latch (50,120) when the input signal is delayed through passing via the back bias applying circuit (52,63), judging that the integrated circuit (2,3) is in a defective holding state.

## Patentansprüche

1. Eine integrierte Schaltung (2), umfassend einen ersten Haltespeicher (110) einer Datenübertragungsquelle, einen zweiten Haltespeicher (50) eines Datenempfangeziels und eine logische Schaltung (130) zwischen dem ersten Haltespeicher (110) und dem zweiten Haltespeicher (50), wobei der zweite Haltespeicher (50) umfasst:
einen Eingangspuffer (51), welcher ein Eingangssignal puffert, das von dem ersten Haltespeicher (110) übertragen wird; und
eine Sperrspannungs-Anlegeschaltung (52), welche eingerichtet ist, um ein zu testendes Signal zu verzögern, indem eine Sperrspannung an dem Eingangspuffer (51) zu einem Zeitpunkt eines Testbetriebs angelegt wird.

2. Eine integrierte Schaltung (3), umfassend einen ersten Haltespeicher (60) einer Datenübertragungsquelle, einen zweiten Haltespeicher (120) eines Datenempfangsziels und eine logische Schaltung (130) zwischen dem ersten Haltespeicher (60) und dem zweiten Haltespeicher (120), wobei der erste Haltespeicher (60) umfasst:
einen Ausgangspuffer (61), welcher ein Signal puffert, das aus dem ersten Haltespeicher (60) ausgegeben wird; und
eine Sperrspannungs-Anlegeschaltung (63), welche eingerichtet ist, um ein zu testendes Signal zu verzögern, indem eine Sperrspannung an dem Ausgangspuffer (61) zu einem Zeitpunkt eines Testbetriebs angelegt wird.

3. Ein Verfahren zum Testen der integrierten Schaltung (2, 3) nach Anspruch 1 oder 2, umfassend:
zuerst Testen, ob ein Eingangssignal, welches die Sperrspannungs-Anlegeschaltung (52, 63) umgeht, in den zweiten Haltespeicher (50, 120) aufgenommen werden kann, und wenn ja, Beurteilen, dass die integrierte Schaltung (2, 3) bestanden hat, und falls das Eingangssignal nicht in den zweiten Haltespeicher (50, 120) aufgenommen werden kann, Beurteilen, dass die integrierte Schaltung (2, 3) defekt ist; und
zweitens Testen, ob das Eingangssignal in den zweiten Haltespeicher (50, 120) aufgenommen werden kann, selbst wenn das Eingangssignal über die Sperrspannungs-Anlegeschaltung (52, 63) verzögert ist, und falls nicht, Beurteilen, dass die integrierte Schaltung (2, 3) in einem Zustand eines Kurzschlusses oder einer Trennung einer Verdrahtung ist, wohingegen falls das Eingangssignal in den zweiten Haltespeicher (50, 120) aufgenommen werden kann, wenn das Eingangssignal durch ein Passieren durch die Sperrspannungs-Anlegeschaltung (52, 63) verzögert ist, Beurteilen, dass die integrierte Schaltung (2, 3) in einem defekten Haltezustand ist.

## Revendications

1. Circuit intégré (2) comprenant un premier verrou (110) d'une source de transmission de données, un second verrou (50) d'une destination de réception de données et un circuit logique (130) entre le premier verrou (110) et le second verrou (50), le second verrou (50) comportant :
un tampon d'entrée (51) qui met en mémoire tampon un signal d'entrée transmis depuis le premier verrou (110) ; et
un circuit appliquant une polarisation inverse (52) disposé pour retarder un signal à tester, en appliquant une polarisation inverse au tampon d'entrée (51) au moment d'une opération de test.

2. Circuit intégré (3) comprenant un premier verrou (60) d'une source de transmission de données, un second verrou (120) d'une destination de réception de données et un circuit logique (130) entre le premier verrou (60) et le second verrou (120), le premier verrou (60) comportant :
un tampon de sortie (61) qui met en mémoire tampon un signal délivré depuis le premier verrou (60) ; et
un circuit appliquant une polarisation inverse (63) disposé pour retarder un signal à tester, en appliquant une polarisation inverse au tampon de sortie (61) au moment d'une opération de test.

3. Procédé de test de circuit intégré (2, 3) selon la revendication 1 ou 2, comportant :
tout d'abord, tester pour savoir si un signal d'entrée, qui contourne le circuit d'application de polarisation inverse (52, 63), peut être entré dans le second verrou (50, 120), et ainsi estimer que le circuit intégré (2, 3) est traversé, et dans l'éventualité où le signal d'entrée ne peut pas être introduit dans le second verrou (50, 120), estimer que le circuit intégré (2, 3) est défectueux ; et
ensuite, tester si le signal d'entrée peut être introduit dans le second verrou (50, 120), même si le signal d'entrée est retardé par l'intermédiaire du circuit d'application de polarisation inverse (52, 63), et si ce n'est pas le cas, estimer que le circuit intégré (2, 3) se trouve dans un état de court-circuit ou de déconnexion d'un câblage, tandis que dans l'éventualité où le signal d'entrée peut être introduit dans le second verrou (50, 120) lorsque le signal d'entrée est retardé par le passage par l'intermédiaire du circuit d'application de polarisation inverse (52, 63), estimer que le circuit intégré (2, 3) se trouve dans un état défectueux de conservation.
